(19) Europäisches Patentamt
European Patent Office
Office européen des brevets

(11) **EP 3 207 388 B1**

(12) **EUROPEAN PATENT SPECIFICATION**

(45) Date of publication and mention of the grant of the patent:
**31.03.2021  Bulletin 2021/13**

(51) Int Cl.:
*G01R 31/36* (2020.01)   *G01R 31/367* (2019.01)
*G01R 31/3828* (2019.01)   *G01R 31/3842* (2019.01)

(21) Application number: **15780869.2**

(22) Date of filing: **14.10.2015**

(86) International application number:
**PCT/EP2015/073808**

(87) International publication number:
**WO 2016/059126 (21.04.2016 Gazette 2016/16)**

(54) **BATTERY CONDITION MONITORING**

BATTERIEZUSTANDSÜBERWACHUNG

SURVEILLANCE D'ÉTAT DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **17.10.2014   GB 201418440**

(43) Date of publication of application:
**23.08.2017   Bulletin 2017/34**

(73) Proprietor: **Jaguar Land Rover Limited Coventry, Warwickshire CV3 4LF (GB)**

(72) Inventor: **GAMA-VALDEZ, Miguel Angel Whitley Coventry CV3 4LF (GB)**

(74) Representative: **Holmes, Matthew William Jaguar Land Rover Patents W/1/073 Abbey Road Whitley, Coventry CV3 4LF (GB)**

(56) References cited:
EP-A1- 1 081 499       EP-A1- 1 336 857
US-A- 4 390 841        US-A1- 2012 153 960
US-A1- 2013 158 916    US-A1- 2014 272 653

**Description**

TECHNICAL FIELD

The present disclosure relates to battery condition monitoring and particularly, but not exclusively, to monitoring the condition of a vehicle battery. Aspects of the invention relate to a system, to a method and to a vehicle, for example an electric vehicle which incorporates the system and or which deploys the method.

BACKGROUND

Electric vehicles having an all-electric powertrain and hybrid electric vehicles, *i.e.* vehicles having both an internal combustion engine powertrain and an electric powertrain (in this specification we refer to both interchangeably as electric vehicles except as where the context requires the two to be distinguished) are becoming more popular. Indeed, electric vehicles may become ubiquitous as demands for reduced localised exhaust emissions increase.

Electric vehicles may have one or more batteries to provide motive power. It is obviously important to know how much power can be provided by the one or more batteries before the battery requires re-charging. A key parameter indicative of the energy stored in a battery is the state-of-charge (SOC). Thus, in order to achieve efficient battery operation and to provide the operator with a reliable gauge, it is important to have an accurate measure of the SOC. As will be appreciated, it is useful to know the SOC in all batteries. Accordingly, this invention is equally applicable to all such batteries, although it is perhaps more critical to determine accurately the SOC in batteries used in vehicles.

The problem of measuring accurately the SOC has been recognised previously.

Known methods of determining the SOC of a battery fall into two camps, they are either (i) very simple and noise-sensitive or (ii) rather precise but highly complex. On one hand, SOC estimation accuracy using simple methods may be significantly diminished in noise contaminated environments because it is difficult for such methods to cope with, for example, long-term drift due to electric current integration (e.g. Coulomb counter), and/or nonlinear behaviour of the battery voltage with respect to the SOC (e.g. Voltage translation). On the other hand, other methods, which use complex regression algorithms, such as nonlinear least squares, do provide more accurate estimates, but usually pose a high cost in terms of computational effort, ECU runtime, as well as development and debugging time.

US6534954 discloses a means for estimating SOC using a Kalman filter or extended Kalman filter and, as such, discloses a complex model-based system which requires intensive calculation.

US 2005/194936 discloses a method of estimating the SOC using a neural network performing a neural network algorithm and a learning algorithm based on data comprising current, voltage and temperature, transmitted thereto from the sensing section, and present time data, thereby outputting the SOC of the battery estimated through a final learning algorithm, and a comparator for comparing an output value of the neural network with a predetermined target value and making the neural network iteratively perform the learning algorithm if a difference between the output value of the neural network and the predetermined target value is outside of a predetermined limit.

US2013/0006455 discloses a method of estimating an open cell voltage (OCV) of a battery and relating the OCV to the SOC via nonlinear mapping.

US2014/272653 discloses a flow battery system including a model of a flow cell stored within the memory, and a processor configured to obtain a current signal and a voltage signal, estimate a state of charge (SOC) of the flow cell using the obtained current signal, compute a model voltage of the flow cell using the obtained current signal, the obtained voltage signal, and the model, compare the model voltage with the obtained voltage signal, calculate a voltage error based upon the comparison of the model voltage with the obtained voltage signal, and correct the estimated SOC based upon the voltage error.

US2013/158916 discloses a system for estimating battery state of charge (SoC) which evaluates a battery model to produce an estimated battery voltage using a previously produced SoC. Current and voltage measurements are combined with the estimated battery voltage to produce a present battery SoC.

US4390841 discloses an apparatus for monitoring energy that a battery power source has remaining. A battery model forms the basis for monitoring with a capacity prediction determined from measurement of the discharge current rate and stored battery parameters. The predicted capacity is used to provide a state-of-charge indication. Self-calibration over the life of the battery power supply is enacted through use of a feedback voltage based upon the difference between predicted and measured voltages to correct the battery mathematical model.

In EP1336857, state of charge is determined by delivering a measure of battery current to an integrator. A feedback path includes a battery modelling unit providing an estimate of battery voltage which is compared with measured battery voltage to produce an error, which is processed to correct measured current applied to the integrator.

US2012/153960 discloses negative peak voltage detection for battery end of life estimations in fuel gauging. By negative peak detection relative to the average battery voltage, the end of life or discharged voltage condition can be altered in response to the negative peaks to obtain the maximum battery life without risk of the device inadvertently shutting down.

EP1081499 discloses a means for estimating a charged state of a battery comprising a start of charge correction calculating means that calculates the correction of the state of charge for equalizing an estimated voltage to a measured voltage.

Accordingly, it is an object of the invention to provide a system to determine, and a method of determining, SOC which circumvent and/or overcome at least one of the problems of the prior art.

SUMMARY OF THE INVENTION

According to an aspect of the present invention there is provided a system for determining the state of charge of a battery. The system comprises a battery model having an input configured to receive an estimated state of charge value, the battery model being configured to generate at least one voltage loss output from which an estimated battery voltage is determined. The or each voltage loss output is representative of the contributions to voltage loss due to a parameter. The system also includes a comparator configured to determine a voltage error between the estimated battery voltage and the actual battery voltage. The battery model is configured to modify an adaptive state of charge weight based on the determined voltage error, and the state of charge is determined by modifying the estimated state of charge with the adaptive state of charge weight. The battery model is configured to back propagate the voltage error to modify the adaptive state of charge weight.

Forward propagation and/or backward propagation through the battery may be performed iteratively.

The system may include a coulomb counter configured to output the estimated state of charge value.

The coulomb counter and the battery model may be provided within a unitary structure, and the structure comprises activation nodes.

The battery current may be provided as an input to the coulomb counter.

The battery state of health may be provided as an input to the coulomb counter.

The coulomb counter portion may be configured to determine the estimated state of charge value by:

$$\beta = \frac{1}{Q} \int_{t_0}^{t} i\, dt + SOC(t_0)$$

The coulomb counter output may be modified by the adaptive state of charge weight for input into the battery model.

A further input to the battery model may comprise one or more of battery current, battery temperature and battery state of health.

The battery model may generate at least two voltage loss outputs, each of the voltage loss outputs being associated with an adaptive voltage contribution weight.

The system may comprise a summation node configured to sum the at least two voltage loss outputs, modified by the associated adaptive voltage contribution weight, to determine the estimated battery voltage.

The battery model may be configured to back propagate the voltage error to modify one or more of the adaptive voltage contribution weights. In this way, the voltage error may be used to amend weights associated to or with one or more nodes.

The battery model may be configured to include contributions to voltage loss from one or more of the following parameters: open-circuit voltage; internal resistance; resistance; capacitance; and polarisation voltage.

According to another aspect of the present invention there is provided a method for determining the state of charge of a battery. The method comprises receiving an estimated state of charge value into a battery model, and generating at least one voltage loss output from the battery model, the or each voltage loss output being representative of the contributions to voltage loss due to a parameter. The method also comprises determining an estimated battery voltage based on the at least one voltage loss output, and determining a voltage error between the estimated battery voltage and the actual battery voltage. The method further comprises modifying an adaptive state of charge weight based on the determined voltage error, and determining the state of charge by modifying the estimated state of charge with the adaptive state of charge weight. The adaptive state of charge weight is modified by back propagating the voltage error through the battery model.

The at least one voltage loss output may include one or more of the internal resistance, polarisation voltage, open cell voltage.

The method may comprise applying voltage contribution weighs to the voltage loss outputs.

The method may comprise determining a voltage error in the estimated battery voltage by comparing the estimated voltage with the actual voltage.

According to a further aspect of the present invention there is provided an electric vehicle having a battery for providing at least a portion of the motive force for the vehicle, the battery having a state of charge, and the vehicle comprising an system as outlined above.

According to a still further aspect of the present invention there is provided a non-transitory, computer-readable storage medium storing instructions thereon that when executed by one or more processors causes the one or more processors to carry out the method outlined above.

Within the scope of this application it is expressly intended that the various aspects, embodiments, examples and alternatives set out in the preceding paragraphs, in the claims and/or in the following description and drawings, and in particular the individual features thereof, may be taken independently or in any combination. That is, all embodiments and/or features of any embodiment can be combined in any way and/or combination, unless such features are incompatible. The applicant reserves the right to change any originally filed claim or file any new claim accordingly, including the right to amend any originally filed claim to depend from and/or incorporate any feature of any other claim although not originally claimed in that manner.

BRIEF DESCRIPTION OF THE DRAWINGS

Embodiments of the present invention will now be described, by way of example only, with reference to the accompanying drawings, in which:

Figure 1 is a schematic representation of a battery model;

Figure 2 is a schematic representation of an adaptive structure according to an embodiment of the present invention;

Figure 3 is a further representation of the structure of Figure 2;

Figure 4 is a flow diagram of an algorithm according to an embodiment of the present invention;

Figure 5 is a computer simulation of a drive cycle using the structure of Figure 2, and

Figure 6 is a schematic representation of an adaptive structure according to another embodiment of the invention.

DETAILED DESCRIPTION

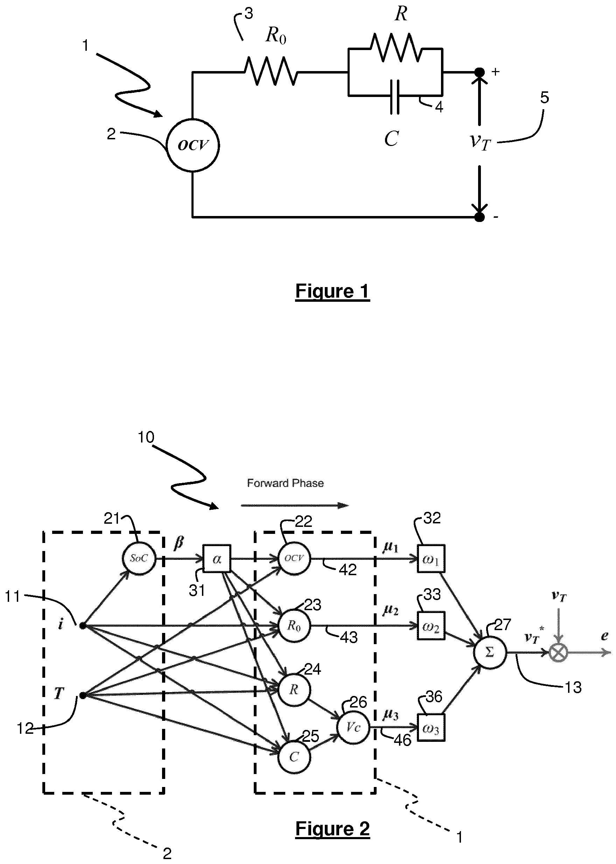

Referring first to Figure 1, there is shown a battery model 1 which describes the electrical behaviour of a battery in transient and steady conditions. The battery model 1 takes into consideration dynamic contributions related to the OCV 2, the ohmic loss ($R_o$) 3, polarization time constants ($1/RC$) 4 to provide an output 5 relating to the battery voltage ($V_T$). The battery model 1 may include inputs for other dynamic contributions such as hysteresis (*e.g.* electrochemical or electromechanical hysteresis) and thermal effects. The associated parameters are known to be nonlinear functions of the SOC and temperature.

The battery SOC can be defined as the ratio between the actual charge stored in the battery with respect to its nominal capacity. A simple method to calculate the charge stored in the battery at a given time consists on integrating the battery current over time. This method is called Coulomb Counting and can be expressed as follows:

$$SOC(t) = \frac{1}{Q}\int_{t_0}^{t} i\,dt + SOC(t_0) \qquad (1)$$

Thus, the SOC at any particular time t may be determined by considering the total current flow over time. It will be appreciated that an initial value of the SOC ($SOC(t_0)$) and the nominal battery capacity (Q) are required to perform equation (1).

The battery model 1 is deployed within an adaptive structure 10, as seen in Figure 2. In general, the adaptive structure 10 comprises the battery model 1 and a coulomb counter 2. This is embodied by plural activation nodes (indicated by circles) and plural adaptive gains or weights (indicated by squares). As shown in the adaptive structure 10, the inputs 11, 12 are respectively battery current (*i*) and battery temperature (*T*) and the output 13 is an estimation of the battery voltage ($V_T$).

The activation function implemented in the SOC node 21 is described by (1), repeated below as equation (2) with slightly different terminology:

$$\beta = \frac{1}{Q}\int_{t_0}^{t} i\,dt + SOC(t_0) \qquad (2)$$

The output, β, is a first, estimated or raw, value of the SOC of the battery. This is corrected by an adaptive state of charge weight α 31, such that:

$$SOC^* = \beta \cdot \alpha \qquad (3)$$

The battery model 1 comprises five nodes 22-26 representing, respectively the contributions from the losses due to the following parameters: open-circuit voltage $OCV$, internal resistance $R_0$, resistance $R$, capacitance $C$, polarisation voltage $Vc$.

As shown, the output from the coulomb counter 2 (as modified by equation (3)) and the second input 12 are the inputs to the first node 22 of the battery model 1. The output from the coulomb counter 2 (as modified by equation (3)) and the first and second inputs 11, 12 are the inputs to the second node 23 of the battery model 1. The output from the coulomb counter 2 (as modified by equation (3)) and the first and second inputs 11, 12 are the inputs to the third node 24 of the battery model 1. The output from the coulomb counter 2 (as modified by equation (3)) and the first and second inputs 11, 12 are the inputs to the fourth node 25 of the battery model 1. The outputs of the third 24 and fourth 25 nodes are the inputs to the fifth node 26 of the battery model 1.

Each node 22, 23, 26 provides a corresponding voltage loss output 42, 43, 46. Each output 42, 43, 46 is linked to an adaptive weight μ, as follows:

$$\mu_1 = OCV(SoC^*, T) \qquad (4)$$

$$\mu_2 = R_0(SoC^*, i, T) \qquad (5)$$

$$\mu_3 = R(SoC^*, T) \cdot \left( i - C(SoC^*, T) \cdot \frac{dV_c}{dt} \right) \qquad (6)$$

Each adaptive weight $\mu_1$, $\mu_2$, $\mu_3$, is modified by a respective node adaptive voltage contribution weight 32, 33, 36, which defines the strength of each node's contribution to the battery voltage, $V_T^*$ as follows:

$$V_T^* = \sum_{i=1}^{3} \mu_i \omega_i \qquad (7)$$

The contribution is determined in summation node 27, from which the value $V_T^*$ is provided as output 13.

The error in the voltage is determined in accordance with equation (9) below.

The combination of the battery model 1 and the coulomb counter 2 within an adaptive structure 10 allows the use of powerful leaning algorithms, such as a Back Propagation algorithm (BP). The BP uses the gradient of the output error to tune the adaptive weights 31, 32, 33 and 36 associated with the activation nodes 21, 22, 23 and 26.

To minimise the SOC estimation error, the following index is considered:

$$J = \sum_{i=0}^{N} \frac{1}{2} e_i^2 \qquad (8)$$

where,

$$e = V_T - V_T^* \qquad (9)$$

The voltage error $e$ is then back propagated through the network by tuning the adaptive weights $\alpha$ and $\omega$ as follows:

$$\alpha(k+1) = \alpha(k) - \xi \frac{\partial J}{\partial \alpha} \qquad (10)$$

$$\omega_i(k+1) = \omega_i(k) - \eta \frac{\partial J}{\partial \omega_i} \; ; \; i = 1,2,3. \qquad (11)$$

where $\eta$ and $\xi$ are used as learning factors, which define the speed at which the error is minimised; $k$ is the time sample.

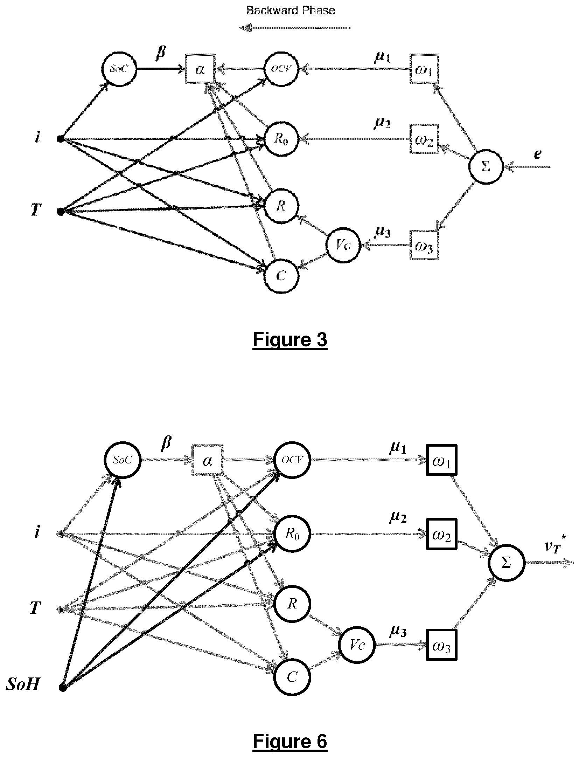

The use of the learning algorithm is split into two phases: Forward and Backward phase. In the Forward phase (Figure 2) the voltage error is calculated; all weights 32, 33, 36 are kept fixed and, at every sampling interval the adaptive weights $\mu_{1-3}$ are updated using equations 4 to 6 above and the value of SOC* from equation 3. In the Backward phase (Figure 3) the error is back-propagated to tune the adaptive weights 31, 32, 33, 36 as per equations 10 and 11.

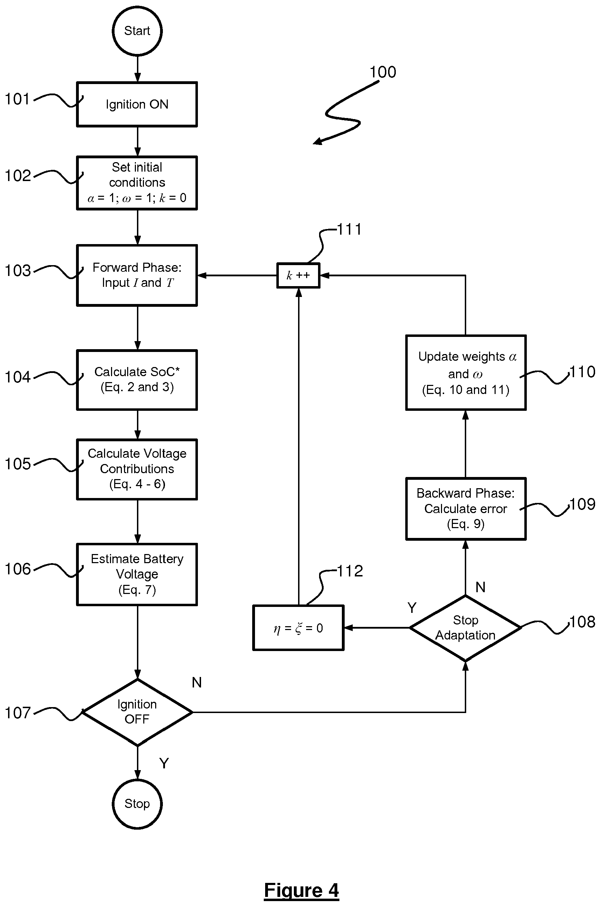

Figure 4 shows a flow diagram 100 of operation of the proposed algorithm to provide an accurate determination of SOC.

The flow diagram 100 commences with turning on the ignition 101 (or the 'wake-up' signal of the ECU where the SOC algorithm is embedded within the ECU or associated computing means), and setting the initial weight conditions 102. The instantaneous values for $i$ and $T$ are provided 103 as inputs 12 and 13 to allow the coulomb counter 2 to generate a value of SOC* 104. The voltage contributions are determined 105 using the battery model 1 and the battery voltage is estimated 106 to provide output 13, *i.e.* in accordance with the description of Figure 2.

If, at decision point 107, the ignition is not set or turned to 'off' the flow diagram runs to an adaptation decision point 108. At the first iteration the BP will be run 109 to calculate the voltage error e and to back propagate 110 through the model 1 to update the adaptive weights 31, 32, 33, 36, *i.e.* in accordance with the description of Figure 3. The iteration step is then updated 112 and the new values for adaptive weights 31, 32, 33, 36 are used in the forward propagation steps 103 to 106.

During an iteration, the error e will become or at least tend towards zero. If the error e is zero, or at least below a predetermined value, the adaption decision 108 will stop the BP and the learning factors $\eta$ and $\xi$ will be set to zero 112. At this stage $\mu(k+1) = \mu(k)$ and $\omega(k+1) = \omega(k)$ and the adaptive weights 31, 32, 33, 36 are at the optimum level to allow an accurate calculation of SOC. At this stage, the adaptive structure 10 becomes a usual coulomb counter 2 because the battery model 1 is no longer functioning as such.

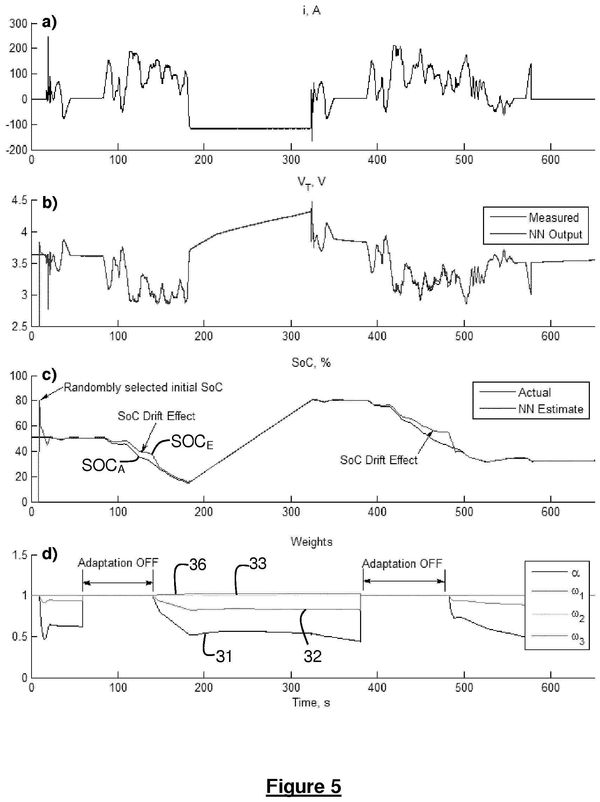

Referring to Figure 5, there is a shown a computer simulation of a typical 600 second drive cycle which depicts the effects of inaccurate SOC initialisation and sensor errors.

Figure 5a shows the input current $i$, as it varies over the sampling time frame. Figure 5b shows the estimated voltage $V_T$ and actual voltage $V$, Figure 5c shows the variation of both actual ($SOC_A$) and estimated SOC ($SOC_E$) and Figure 5d shows the variation in the adaptive weights 31, 32, 33, 36 over time with periods where the adaption 109, 110 has been stopped.

As can be seen, the adaptive structure 10 accurately determines the value of the SOC using the battery model 1 and coulomb counter 2 and the Backward phase to generate the appropriate weights 31, 32, 33, 36.

As seen in Figures 5c and 5d, the estimated SOC ($SOC_E$) quickly and effectively mirrors the actual SOC ($SOC_A$) using the method and system of the invention when the invention is in use and deviation occurs ('SOC Drift Effect') between the estimated and actual values when the invention is not in use ('adaptation off in Figure 5d).

The adaptive structure 10 has been shown to demonstrate a high level of accuracy in estimating SOC with much less mathematical foundation that at least some of the prior art methods which use Kalman-type filters and the like. Because of the simplicity of the model 1, and the deployment of the known coulomb counting functionality the method and system is easier to implement and deploy and has reduced debugging and development time. Moreover, because the structure 10 is self-adaptive there is no need for calibration. The self-adaptive nature of the structure 10 ensures that there is no requirement for off-line training as is most usually required for state of the art neural network-based approaches for determining the SOC. This is because voltage measurements are used to calculate the network error which allows for an indirect adjustment of the estimated SOC value.

In another embodiment as seen in Figure 6, the battery state of health (SOH) can be used to adjust the node's activation functions. The SOH may be comprised of two main components: a capacity fade component fed into nodes 21 and 22 of Fig 2, and a power fade component fed into node 23.

The SOH is typically presented as a ratio or proportion of the operating health of the battery in relation to the optimal SOH, which may be an ideal characteristic or the characteristic of the battery as manufactured. It is known that the SOH can be determined by using one or more of, for example, internal resistance, impedance, conductance, capacity, voltage, self-discharge, chargeability. In which case the, for example, power fade of the battery relates to the SOH. The SOH at any time t thereafter is given as:

$$SOH(IR_{t=t}) = IR_{t=0}/IR_{t=t} \qquad (12)$$

The back propagation routine can be utilised to provide an accurate determination of the SOC, in accordance with the above-description. In this instance the SOH is provided as an input to further improve the robustness of the SOC estimation.

In order to determine the efficacy of the inventive method, we constructed three simulations one of the inventive method set out above, one using a traditional coulomb counter and a third using an extended Kalman filter.

In each case code was auto-generated using Matlab®'s Embedded Coder using fixed-point data types. Code was then flashed onto the dsPIC33EP512MU810 controller from MICROCHIP®. The controller was then used within a simulation platform to emulate the battery behaviour under typical drive cycles and within representative environmental conditions. SOC update rate was set to 10ms.

The execution time of each algorithm and root mean square error (RMSE) are shown in the table below. The RMSE was calculated over the Artemis Motorway drive cycle against a reference SOC from a reference model running in a National Instruments PXI® platform.

| | SOC Estimation Method | | |
|---|---|---|---|
| | This Invention | Coulomb Counter | Extended Kalman Filter |
| Execution time /ms | $0.8 \times 10^{-3}$ | $0.2 \times 10^{-3}$ | 0.73 |
| RMSE | 1.6% | 3.85% | 0.8% |

As can be seen, the model of the current invention had an execution time comparable to that of the simple Coulomb counter model but an RMSE comparable to that of the complex and time consuming Extended Kalman Filter model, thereby demonstrating that the model of the invention can generate low error results in a fraction of the time taken to achieve similar results utilising the prior art.

The above description outlines the usefulness of the invention. In the first instance simple inputs can be used to obtain useful information. In the second instance a simple back propagation protocol is used iteratively to amend the weights and thereby increase the accuracy of the methodology and the result. This is achieved without complex neural networks and/or off-line training protocols which makes this invention easier to deploy, faster and less costly than prior art methodologies whilst providing the requisite low error measurements.

It will further be appreciated by the skilled addressee that if the adaptive algorithm is turned off, for example to further decrease execution time or to decrease complexity, the system will revert to a simple Coulomb counter model.

It will be appreciated that the methodology disclosed herein is particularly useful in a vehicular environment, it may also be deployed in other environments where knowledge of the state of charge of a battery is critical or useful, for example in back-up plant for industrial or other equipment, mobile phones and so on.

## Claims

1. A system for determining the state of charge of a battery; the system comprising:

   a battery model (1) having an input configured to receive an estimated state of charge value, the battery model being configured to generate at least one voltage loss output (42, 43, 46) from which an estimated battery voltage is determined, the or each voltage loss output being representative of the contributions to voltage loss due to a parameter; and
   a comparator configured to determine a voltage error between the estimated battery voltage and the actual battery voltage,
   the system **characterised in that**:

   the battery model is configured to modify an adaptive state of charge weight based on the determined voltage error,
   wherein the state of charge is determined by modifying the estimated state of charge with the adaptive state of charge weight, and
   wherein the battery model is configured to back propagate the voltage error to modify the adaptive state of charge weight.

**2.** A system according to Claim 1, comprising a coulomb counter (2) configured to output the estimated state of charge value.

**3.** A system according to Claim 2, wherein the coulomb counter and the battery model are provided within a unitary structure, and the structure comprises activation nodes.

**4.** A system according to Claim 2 or Claim 3, wherein the battery current is provided as an input to the coulomb counter.

**5.** A system according to any of Claims 2 to 4, wherein the battery state of health is provided as an input to the coulomb counter.

**6.** A system according to any of Claims 2 to 5, wherein the coulomb counter portion is configured to determine the estimated state of charge value by:

$$\beta = \frac{1}{Q} \int_{t_0}^{t} i \, dt + SOC(t_0)$$

**7.** A system according to any previous claim, the estimated state of charge being modified by the adaptive state of charge weight for input into the battery model.

**8.** A system according to any previous claim, wherein a further input to the battery model comprises one or more of battery current, battery temperature and battery state of health.

**9.** A system according to any previous claim, wherein the battery model generates at least two voltage loss outputs, each of the voltage loss outputs being associated with an adaptive voltage contribution weight.

**10.** A system according to Claim 9, comprising a summation node (27) configured to sum the at least two voltage loss outputs, modified by the associated adaptive voltage contribution weight, to determine the estimated battery voltage.

**11.** A system according to Claim 9 or Claim 10, wherein the battery model is configured to back propagate the voltage error to modify one or more of the adaptive voltage contribution weights.

**12.** A method for determining the state of charge of a battery; wherein the method is executed by one or more processors and comprises:

receiving an estimated state of charge value into a battery model;
generating at least one voltage loss output from the battery model, the or each voltage loss output being representative of the contributions to voltage loss due to a parameter;
determining an estimated battery voltage based on the at least one voltage loss output;
determining a voltage error between the estimated battery voltage and the actual battery voltage;
the method **characterised by**:

modifying an adaptive state of charge weight based on the determined voltage error; and
determining the state of charge by modifying the estimated state of charge with the adaptive state of charge weight,

wherein the adaptive state of charge weight is modified by back propagating the voltage error through the battery model.

**13.** An electric vehicle having a battery for providing at least a portion of the motive force for the vehicle, the battery having a state of charge, and the vehicle comprising a system according to any of Claims 1 to 11.

**14.** A non-transitory, computer-readable storage medium storing instructions thereon that when executed by one or more processors causes the one or more processors to carry out the method of Claim 12.

**Patentansprüche**

1. System zum Bestimmen des Ladezustands einer Batterie;
   wobei das System Folgendes umfasst:

   ein Batteriemodell (1), das einen Eingang aufweist, der konfiguriert ist, um einen geschätzten Ladezustandswert zu empfangen, wobei das Batteriemodell konfiguriert ist, um wenigstens eine Spannungsverlustausgangsleistung (42, 43, 46) zu erzeugen, aus der eine geschätzte Batteriespannung bestimmt wird, wobei die oder jede Spannungsverlustausgangsleistung darstellend für die Beiträge zu dem Spannungsverlust aufgrund eines Parameters ist; und
   einen Komparator, der konfiguriert ist, um einen Spannungsfehler zwischen der geschätzten Batteriespannung und der tatsächlichen Batteriespannung zu bestimmen, wobei das System **dadurch gekennzeichnet ist, dass**: das Batteriemodell konfiguriert ist, um ein adaptives Ladezustandsgewicht basierend auf dem bestimmten Spannungsfehler zu modifizieren, wobei der Ladezustand durch das Modifizieren des geschätzten Ladezustands mit dem adaptiven Ladegewicht bestimmt wird, und wobei das Batteriemodell konfiguriert ist, um den Spannungsfehler rückzupropagieren, um das adaptive Ladezustandsgewicht zu modifizieren.

2. System nach Anspruch 1, das einen Coulomb-Zähler (2) umfasst, der konfiguriert ist, um den geschätzten Ladezustand auszugeben.

3. System nach Anspruch 2, wobei der Coulomb-Zähler und das Batteriemodell innerhalb einer unitären Struktur bereitgestellt sind, und die Struktur Aktivierungsknoten umfasst.

4. System nach Anspruch 2 oder 3, wobei der Batteriestrom als eine Eingangsleistung für den Coulomb-Zähler bereitgestellt ist.

5. System nach einem der Ansprüche 2 bis 4, wobei der Gesundheitszustand der Batterie als eine Eingangsleistung für den Coulomb-Zähler bereitgestellt ist.

6. System nach einem der Ansprüche 2 bis 5, wobei der Coulomb-Zähleranteil konfiguriert ist, um den geschätzten Ladezustandswert durch Folgendes zu bestimmen:

$$\beta = \frac{1}{Q}\int_{t_0}^{t} i\,dt \;+\; SOC(t_0)$$

7. System nach einem der vorhergehenden Ansprüche, wobei der geschätzte Ladezustand durch das adaptive Ladezustandsgewicht für die Eingangsleistung in das Batteriemodell modifiziert wird.

8. System nach einem der vorhergehenden Ansprüche, wobei eine fernere Eingangsleistung an das Batteriemodell den Batteriestrom, eine Batterietemperatur und/oder den Gesundheitszustand einer Batterie umfasst.

9. System nach einem der vorhergehenden Ansprüche, wobei das Batteriemodell wenigstens zwei Spannungsverlustausgangsleistungen erzeugt, wobei jede der Spannungsverlustausgangsleistungen mit einem adaptiven Spannungsbeitragsgewicht verknüpft ist.

10. System nach Anspruch 9, das einen Summierungsknoten (27) umfasst, der konfiguriert ist, um die wenigstens zwei Spannungsverlustausgangsleistungen zu summieren, die durch das verknüpfte adaptive Spannungsbeitragsgewicht modifiziert sind, um die geschätzte Batteriespannung zu bestimmen.

11. System nach Anspruch 9 oder 10, wobei das Batteriemodell konfiguriert ist, um den Spannungsfehler rückzupropagieren, um eines oder mehrere der adaptiven Spannungsbeitragsgewichte zu modifizieren.

12. Verfahren zum Bestimmen des Ladezustands einer Batterie;

    wobei das Verfahren durch einen oder mehrere Prozessoren ausgeführt wird und Folgendes umfasst:

    Empfangen eines geschätzten Ladezustandswerts in ein Batteriemodell;

Erzeugen wenigstens einer Spannungsverlustausgangsleistung aus dem Batteriemodell, wobei die oder jede Spannungsverlustausgangsleistung darstellend für die Beiträge zu dem Spannungsverlust aufgrund eines Parameters ist;
Bestimmen einer geschätzten Batteriespannung basierend auf der wenigstens einen Spannungsverlustausgangsleistung;
Bestimmen eines Spannungsfehlers zwischen der geschätzten Batteriespannung und der tatsächlichen Batteriespannung;

wobei das Verfahren durch Folgendes gekennzeichnet ist:

Modifizieren eines adaptiven Ladegewichtszustandszustands basierend auf dem bestimmten Spannungsfehler; und
Bestimmen des Ladezustands durch das Modifizieren des geschätzten Ladezustands mit dem adaptiven Ladezustandsgewicht, wobei das adaptive Ladezustandsgewicht durch das Rückpropagieren des Spannungsfehlers durch das Batteriemodell hindurch modifiziert wird.

13. Elektrofahrzeug, das eine Batterie zum Bereitstellen von wenigstens einem Anteil der Antriebskraft für das Fahrzeug aufweist, wobei die Batterie einen Ladezustand aufweist und das Fahrzeug ein System nach einem der Ansprüche 1 bis 11 umfasst.

14. Nicht flüchtiges, computerlesbares Speichermedium, das darauf Anweisungen speichert, die, wenn durch einen oder mehrere Prozessoren ausgeführt, den einen oder die mehreren Prozessoren veranlassen, das Verfahren nach Anspruch 12 vorzunehmen.

**Revendications**

1. Système destiné à déterminer l'état de charge d'une batterie ;
le système comprenant :

un modèle de batterie (1) ayant une entrée configurée pour recevoir une valeur d'état de charge estimée, le modèle de batterie étant configuré pour générer au moins une sortie de perte de tension (42, 43, 46) à partir de laquelle une tension de batterie estimée est déterminée, la ou chaque sortie de perte de tension étant représentative des contributions à la perte de tension attribuables à un paramètre ; et
un comparateur configuré pour déterminer une erreur de tension entre la tension de batterie estimée et la tension de batterie réelle, le système étant **caractérisé en ce que** :
le modèle de batterie est configuré pour modifier un poids adaptatif d'état de charge en fonction de l'erreur de tension déterminée, dans lequel l'état de charge est déterminé en modifiant l'état de charge estimé avec le poids adaptatif d'état de charge, et dans lequel le modèle de batterie est configuré pour rétropropager l'erreur de tension afin de modifier le poids adaptatif d'état de charge.

2. Système selon la revendication 1, comprenant un compteur de coulombs (2) configuré pour délivrer la valeur d'état de charge.

3. Système selon la revendication 2, dans lequel le compteur de coulombs et le modèle de batterie sont fournis à l'intérieur d'une structure unitaire, et la structure comprend des noeuds d'activation.

4. Système selon la revendication 2 ou la revendication 3, dans lequel le courant de batterie est fourni en tant qu'entrée au compteur de coulombs.

5. Système selon l'une quelconque des revendications 2 à 4, dans lequel l'état de santé de la batterie est fourni en tant qu'entrée du compteur de coulombs.

6. Système selon l'une quelconque des revendications 2 à 5, dans lequel la partie compteur de coulombs est configurée pour déterminer la valeur d'état de charge estimée par :

$$\beta = \frac{1}{Q} \int_{t_0}^{t} i\,dt + SOC(t_0)$$

7. Système selon une quelconque revendication précédente, l'état de charge estimé étant modifié par le poids adaptatif d'état de charge pour l'entrée dans le modèle de batterie.

8. Système selon une quelconque revendication précédente, dans lequel une autre entrée du modèle de batterie comprenant le courant de batterie, et/ou la température de la batterie et/ou l'état de santé de la batterie.

9. Système selon une quelconque revendication précédente, dans lequel le modèle de batterie génère au moins deux sorties de perte de tension, chacune des sorties de perte de tension étant associée à un poids adaptatif de contribution de tension.

10. Système selon la revendication 9, comprenant un nœud de sommation (27) configuré pour additionner les au moins deux sorties de perte de tension, modifiées par le poids adaptatif de contribution de tension associé, pour déterminer la tension de batterie estimée.

11. Système selon la revendication 9 ou la revendication 10, dans lequel le modèle de batterie est configuré pour rétropropager l'erreur de tension afin de modifier un ou plusieurs des poids adaptatifs de contribution de tension.

12. Procédé destiné à déterminer l'état de charge d'une batterie ;

dans lequel le procédé est exécuté par un ou plusieurs processeurs et comprend :

la réception d'une valeur d'état de charge estimée dans un modèle de batterie ;
la génération d'au moins une sortie de perte de tension à partir du modèle de batterie, la ou chaque sortie de perte de tension étant représentative des contributions à la perte de tension attribuables à un paramètre ;
la détermination d'une tension de batterie estimée en fonction de l'au moins une sortie de perte de tension ;
la détermination d'une erreur de tension entre la tension de batterie estimée et la tension de batterie réelle ;

le procédé étant **caractérisé par** :

la modification d'un poids adaptatif d'état de charge en fonction de l'erreur de tension déterminée ; et
la détermination de l'état de charge en modifiant l'état de charge estimé avec le poids adaptatif d'état de charge, dans lequel le poids adaptatif d'état de charge est modifié en rétropropageant l'erreur de tension à travers le modèle de batterie.

13. Véhicule électrique ayant une batterie destinée à fournir au moins une partie de la force motrice au véhicule, la batterie ayant un état de charge, et le véhicule comprenant un système selon l'une quelconque des revendications 1 à 11.

14. Support de stockage non transitoire lisible par ordinateur stockant des instructions de stockage sur celui-ci qui, lorsqu'elles sont exécutées par un ou plusieurs processeurs, amènent les un ou plusieurs processeurs à mettre en œuvre le procédé selon la revendication 12.

**Figure 1**

**Figure 2**

Backward Phase

Figure 3

Figure 6

**Figure 4**

**Figure 5**

## REFERENCES CITED IN THE DESCRIPTION

**Patent documents cited in the description**

- US 6534954 B
- US 2005194936 A
- US 20130006455 A
- US 2014272653 A
- US 2013158916 A
- US 4390841 A
- EP 1336857 A
- US 2012153960 A
- EP 1081499 A